# EUROPEAN PATENT APPLICATION

(11) **EP 0 581 305 A2**
(43) Date of publication of application: **02.02.1994**
(21) Application number: 93112253.5
(22) Date of filing: 30.07.1993
(51) Int. Cl.: H01L 21/338, H01L 21/28, H01L 29/08

(54) **Field-effect transistor and method for fabricating the same**

(30) Priority: 30.07.1992 JP 203503/92; 07.12.1992 JP 326812/92; 23.03.1993 JP 64104/93
(71) Applicant: Sumitomo Electric Industries, Ltd., Osaka 541 (JP)
(72) Inventor: Nakajima, Shigeru, c/o Yokohama Works of Sumitomo, Yokohama-shi, Kanagawa (JP); Matsuzaki, Ken-ichiro, c/o Yokohama Works Sumitomo, Yokohama-shi, Kanagawa (JP)
(74) Representative: Kahler, Kurt, Dipl.-Ing.

(57) **Abstract**

There is disclosed a process for fabricating a field-effect transistor comprising: a first step of implanting ions in a semiconductor substrate (1) to form an active layer (3); a second step of forming a dummy gate on the semiconductor substrate (1), and implanting a dopant in the semiconductor substrate (1) with the dummy gate as a mask to form a first doped layer (6); a third step of reducing a conifiguration of the dummy gate, and implanting a dopant in the semiconductor substrate to form a second doped layer (7); a fourth step of forming an insulating film (8) using said reduced dummy gate; and a fifth step of removing a part of the insulating film on the first doped layer (6), forming an ohmic electrode (10; 11) in the region with the insulating film (8) removed, lifting off the insulating film using said reduced dummy gate, and forming a gate electrode (12) in the lifted-off region.

## Description

### BACKGROUND OF THE INVENTION

### Field of the Invention

This invention relates to a field-effect transistor (FET) having a short gate length which is suitably used in high-frequency devices, etc., and to a process for fabricating the same.

### Related Background Art

FETs formed of compound semiconductors, such as GaAs, etc., are very prospective devices as very high-speed devices, high frequency devices, etc. For the purpose of improving high-frequency characteristics of such FETs generally their gate lengths are shortened. But, on the other hand, the shortening of the gate lengths causes short channel effect, which deteriorates the device characteristics. The short channel effect takes place conspicuously in a FET in which an n⁺ layer of the source and the drain regions is formed in self-alignment with the gate electrode, and a main cause is considered to be leak currents flowing from the n⁺ layer to the underside of the channel layer.

The following art have been conventionally used to suppress this short channel effect. As first art, a semiconductor layer having a conduction opposite to that of the channel layer, e.g., a p-semiconductor layer in the case that the channel layer is of n type, is buried below the channel layer. This first art can suppress leak currents flowing from the n⁺ layer to below the channel layer due to a potential barrier formed between the n-channel layer and the p-buried layer.

As second art, n⁺ layers formed below an ohmic electrode for the purpose of decreasing a source resistance are thinned. This second means reduces parts of the n⁺ layers extended beyond the channel layer toward the substrate. so that leak currents flowing between the n⁺ layers are suppressed.

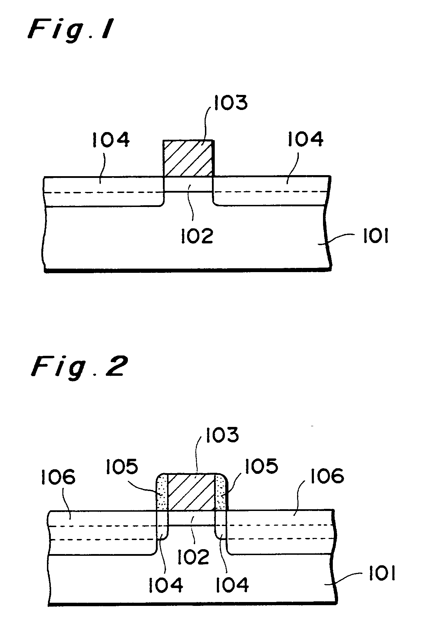

As third art, the LDD (Lightly Doped Drain) structure is used, and low-concentration n⁻ layers are formed between a channel layer and an n⁺ layer. A FET using the LDD structure is fabricated by following the steps of FIGs. 1 and 2. A channel layer 102 is formed on a semiconductor substrate 101, e.g., of GaAs, and a Schottky gate electrode 103 is formed in a gate region. A dopant is implanted with the gate electrode 103 as the mask to form the n⁻layers 104 of a lower concentration (FIG. 1). Next, a side wall 105 is formed on a side walls of the gate electrode 103 and dopant is implanted using this side wall 105 and the gate electrode 103 as a mask, at higher concentration than that of n⁻layer 104, to form n⁺layer 106 (see FIG. 2). In a FET of the thus-fabricated LDD structure, concentration of an electric field generated at the end portion of the drain region is mitigated by the n⁻layers 104 adjacent to the channel layer 102, and leak currents flowing from the n⁺layer 106 to below the channel layer 102 is suppressed.

These conventional art for suppressing the short-channel effect have the following problems.

In the first art, a dopant concentration and a thickness of the p-buried layer below the n-channel layer are set critically for the complete depletion of the p-buried layer due to a potential difference in the pn junction between the n-channel layer and the p-buried layer, while it is necessary to minimize the dopant concentration so as not to increase a parasitic capacity of the FET. Accordingly although a sufficient potential barrier is formed between the n-channel layer and the p-buried layer, a sufficient potential barrier is not formed between the n⁺layer and the p-buried layer, and leak currents from the n⁺layer into the semiconductor substrate cannot be sufficiently suppressed. Furthermore, because Be and Mg which are dopants for the p-buried layer diffuse transversely when activated, the diffusion raises a concentration below an n-channel layer in the presence of the p-channel layer of a high concentration very near the end portion of the gate electrode. Accordingly a parasitic capacity of the FET increases, and good high-frequency characteristics cannot be obtained. This is a problem of the first art.

In the second art, as the n⁺layers are increasingly thinned, resistances of the source and the drain regions increase, and with increases of the source resistance, a contact resistance of the ohmic electrode increases. Accordingly high-frequency characteristics of the device cannot be exhibited.

In the third art, the material of the gate electrode 103 is limited to highly heat-resistant metals. This is because the step of FIG. 2 must be followed by an annealing step of activating the doped regions. Such highly heat-resistant metals have so high resistances that they are not suitable for devices, such as low-noise devices which require low gate resistances. In the case that the side walls 105 are thin, the n⁺layers 106 and the end portion of the gate electrode 103 are brought nearer, and the short channel effect is increased. Reversely in the case that the side walls 105 are thick, the n⁺layer 106 and the end portion of the gate electrode 103 are remotely spaced from each other, and the source resistance is high. On the other hand, to overcome the short channel effect, the n⁻layer 104 is made deeper or more heavily doped, which also results in the short channel effect. Accordingly in practical MESFETs having the n⁺layers 106 formed in self-alignment, the gate length is limited to about 0.5 µm. In the case that the n⁺layers 106 are formed using the highly heat-resistant gate electrode 103, a gate length is determined by the first patterning for the formation of the heat-resistant gate electrode 103, and it is impossible to form a gate length below 0.5 µm by the optical exposure. Such difficulty in shortening the gate length is a barrier to the improvement of the high-frequency characteristics of FETs.

An object of this invention is to solve these problems and to provide a process for fabricating an FET a gate length of which is long and which has superior high-frequency characteristics.

### SUMMARY OF THE INVENTION

To solve the above-described problems, a process for fabricating field-effect transistors comprising a first step of implanting ions in a semiconductor substrate to form an active layer; a second step of forming a dummy gate on the semiconductor substrate, and implanting a dopant in the semiconductor substrate with the dummy gate as a mask to form a first doped layer; a third step of reducing a configuration of the dummy gate, and implanting a dopant in the semiconductor substrate to form a second doped layer; a fourth step of forming an insulating film using said reduced dummy gate; and a fifth step of removing a part of the insulating film on the first doped layer, forming an ohmic electrode in the region with the insulating film removed, lifting off the insulating film using the dummy gate, and forming a gate electrode in the lifted-off region.

According to this process, after the first doped layer is formed with the dummy gate as the mask, a part of the sidewalls of the dummy gate is removed by, e.g., plasma etching to reduce a configuration of the dummy gate. With the reduced dummy gate as the mask, the second doped layer is formed, and with the reversed pattern of the reduced dummy gate the gate electrode is formed. Since configurations of the dummy gate are reduced by, e.g., plasma etching, the gate electrode can easily have a gate length below 0.5 µm by even optical exposure.

Thus, the second doped layer is formed while a configuration of the dummy gate as the mask is reduced. Accordingly it is not necessary to initially form the dummy gate small, and a patterning technique of high precision is not necessary.

By varying decreases of configurations of the dummy gate the gap between the first doped layer for the source and the drain regions to be formed in, and the gate electrode can be freely adjusted. Because the gate electrode is formed after the formation of the doped layers for the LDD structure, the formation of the gate electrode is not followed by an annealing step. Accordingly the gate metal can be selected from a wider selection range.

A field-effect transistor according to this invention includes an active layer for a channel to be formed in, a first doped layer including a source and a drain regions which are in contact with the active layer, and a gate electrode formed on the active layer, the field-effect transistor comprising a plurality of second doped layers between the active layer and the first doped layer.

According to this field-effect transistor, decreases of configurations of the dummy gate can be freely selected. Accordingly by defining regions of a substrate for dopants to be implanted in with ones of the dummy gate having configurations reduced, a source and a drain regions having optional dopant profiles can be obtained. As a result, a source and a drain regions can be formed without excessively widening a gap between the heavily doped layer and the active layer, and with suppressed increases of the source resistance, a gate electrode of a short gate length can be formed. Since an impurity content of the substrate is decreased toward the active layer below the gate electrode, concentration of an electric field at the end portion of the drain region is mitigated.

A field-effect transistor according to this invention comprises an active layer for a channel to be formed in contact with the active layer, a first doped layer of a first conduction type first doped layer including a source region and a drain region, an ohmic electrode formed on the first doped layer, a gate electrode formed on the active layer, and a second doped layer including, between the active layer and the first doped layer, a lower doped layer of a second conduction, and a upper doped layer of a first conduction formed on the lower doped layer, a boundary between the lower and the upper doped layers being shallower than the first doped layer, and a lower end portion of the lower doped layer being deeper than the first doped layer.

According to this field-effect transistor, the lower doped layer and the upper doped are formed on the sidewalls of the first doped layer including the source and the drain regions on the side of the gate electrode. The upper doped layer of the same conduction as the first doped layer functions as the channel layer, and potential barriers are formed in the interface between the lower doped layer of a different conduction from the upper doped layer. The potential barriers can suppress the generation of leak currents flowing from the first undoped layer to below the active layer. Accordingly deterioration of the characteristics due to generation of the short channel effect can be prevented.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

FIG. 1 is a sectional view of a step of a conventional FET fabrication process.

FIG. 2 is a sectional view of a step of a conventional FET fabrication process.

FIG. 3 is a sectional view of a step of the process for fabricating a FET according to a first embodiment of this invention.

FIG. 4 is a sectional view of a step of the process for fabricating a FET according to the first embodiment of this invention.

FIG. 5 is a sectional view of a step of the process for fabricating a FET according to the first embodiment of this invention.

FIG. 6 is a sectional view of a step of the process for fabricating a FET according to the first embodiment of this invention.

FIG. 7 is a sectional view of a step of the process for fabricating a FET according to the first embodiment of this invention.

FIG. 8 is a sectional view of a step of the process for fabricating a FET according to the first embodiment of this invention.

FIG. 9 is a sectional view of a step of the process for fabricating a FET according to a second embodiment of this invention.

FIG. 10 is a sectional view of a step of the process for fabricating a FET according to the second embodiment of this invention.

FIG. 11 is a sectional view of a step of the process for fabricating a FET according to the second embodiment of this invention.

FIG. 12 is a sectional view of a step of the process for fabricating a FET according to the second embodiment of this invention.

FIG. 13 is a sectional view of a step of the process for fabricating a FET according to the second embodiment of this invention.

FIG. 14 is a sectional view of a step of the process for fabricating a FET according to the second embodiment of this invention.

FIG. 15 is a sectional view of a step of the process for fabricating a FET according to the second embodiment of this invention.

FIG. 16 is a sectional view of a FET of structures according to the second embodiment of this invention.

FIG. 17 is a sectional view of a change of the rectangular configuration of the dummy gate according to the second embodiment of this invention.

FIG. 18 is a sectional view of a step of the process for fabricating a FET according to a third embodiment of this invention.

FIG. 19 is a sectional view of a step of the process for fabricating a FET according to the third embodiment of this invention.

FIG. 20 is a sectional view of a step of the process for fabricating a FET according to the third embodiment of this invention.

FIG. 21 is a sectional view of a step of the process for fabricating a FET according to the third embodiment of this invention.

FIG. 22 is a sectional view of a step of the process for fabricating a FET according to the third embodiment of this invention.

FIG. 23 is a sectional view of a step of the process for fabricating a FET according to the third embodiment of this invention.

FIG. 24 is a sectional view of a step of the process for fabricating a FET according to the third embodiment of this invention.

FIG. 25 is a sectional view of a FET of structures according to the third embodiment of this invention.

FIG. 26 is a view of relationships between threshold voltages and gate lengths of the gate electrodes.

FIG. 27 is a view of relationships between current gain cut-off frequencies and source-drain currents.

FIG. 28 shows relationships between the conventional FET and the FET according to the present embodiment.

### DETAILED DESCRIPTION OF THE PREFERRED EMBODIMENTS

Embodiments of this invention will be explained with reference to the drawings attached hereto.

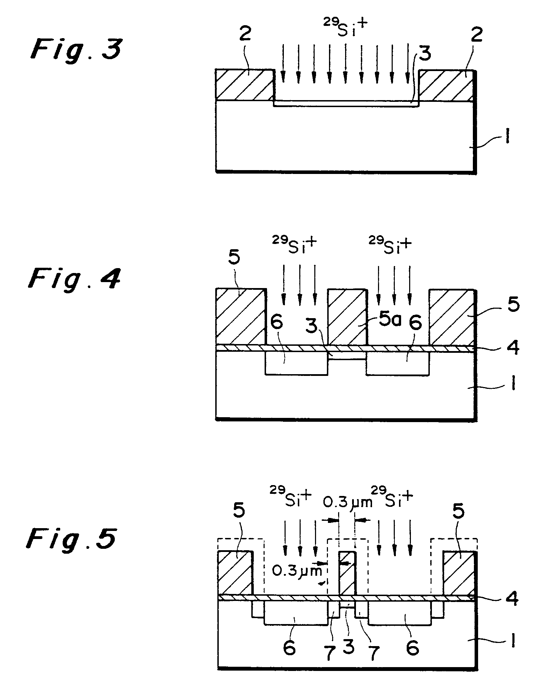

FIGs. 3 to 8 are sectional views of the steps of the process for fabricating a field-effect transistor according to a first embodiment of this invention. First a photo resist 2 is spin-applied to a semi-insulating GaAs semiconductor substrate 1. The photoresist 2 is patterned by photolithography to have a part thereof in a region for an active layer to be formed in selectively removed. With the patterned photoresist 2 as the mask, ²⁹ Si⁺ ions are implanted in a 2x10¹²/cm² does at a 30 keV acceleration voltage. This ion implantation forms an active layer 3 to be a channel is formed on the surface of the semiconductor substrate 1 (FIG. 3).

The removal of the photoresist 2 is followed by the formation of a nitride silicon (SiN) film 4 in a 1000 Å-thickness over the entire surface of the semiconductor substrate 1 by plasma CVD (PCVD). This SiN film 4 not only functions as a protective film against the following annealing, but also serves to protect the surface of the semiconductor substrate 1 through all the steps of the process for fabricating an FET according to this embodiment and to suppress deflections of device characteristics among processes. In other words, in fabricating FETs which allow some deflections in their characteristics among processes, the SiN film 4 is not necessary. Then a photoresist 5 is spin-applied in a 2.0 µm-thickness on the SiN film 4. This photoresist film 5 is patterned by the usual photolithography. That of the photoresist 5 in a gate region is a dummy gate 5a which is to be replaced by a gate electrode in a later step. This dummy gate 5a has a length of about 0.9 µm. With this photoresist 5 as the mask, ²⁹Si⁺ ions are implanted in a 4x10¹³/cm² dose at a 100 keV acceleration voltage, and a first n⁺doped layer 6 is formed (FIG. 4).

Next, the photoresist 5 is isotopically removed by about 0.3 µm by parallel-plate plasma etching of O₂ gas. The dummy gate 5a accordingly has an about 0.3 µm-length. Then with the photoresist 5 as the mask, ²⁹Si⁺ ions are implanted in a 5x10¹²/cm² dose at a 60 keV acceleration voltage, and a second n-doped layer 7 is formed (FIG. 5).

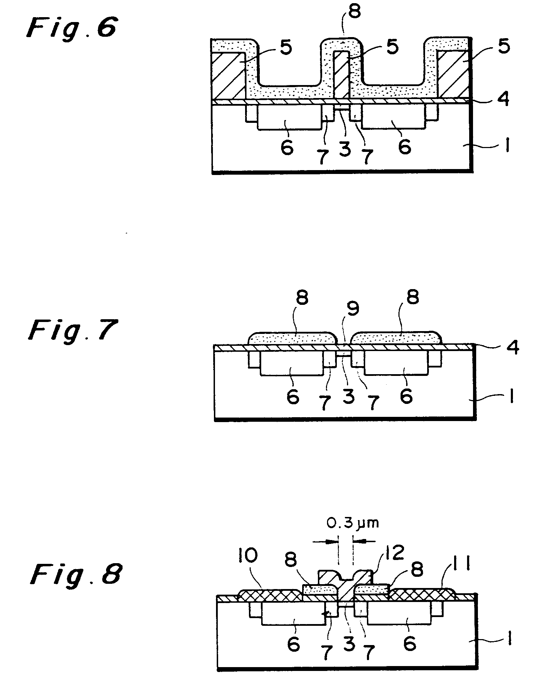

Subsequently a SiO₂ is deposited on the entire surface of the substrate by CVD, of microwave electron cyclotron resonance (ECR) plasma or sputtering, and an insulating film 8 is formed (FIG. 6). Subsequently slight etching using buffered hydrogen fluoride (BHF) is conducted. The slight etching removes the surface of the photoresist 5, and mainly the sidewalls of the insulating film 8 since the insulating film 8 is coarser at the sidewalls than at the top surface. Furthermore, the photoresist 5 is lifted off by boiling with acetone, and a reverse pattern 9 is formed (FIG. 7).

The lift-off is followed by a 20 minute-annealing in an atmosphere of N₂ at about 800 °C, and the doped layers are activated.

Subsequently parts of the insulating film 8 in a source region and in a drain region are partially removed by reactivity ion beam etching (RIBE) and exposed parts of the SiN film 4 are removed by parallel-plasma system etching. On parts of the Semiconductor substrate 1 with the SiN film 4 removed are formed a source electrode 10 and a drain electrode 11. Similarly, the part of the SiN film 4 and the part of the insulating film 8 in the reverse pattern 9 are removed, and a gate electrode 12 is formed which is in Schottky contact with the exposed part of the active layer 3. The end portion of the gate electrode 12 overlaps on the insulating film 8. And a MESFET of the LDD structure of FIG. 8 is completed. Because the gate electrode 12 is formed after the annealing, the Schottky metal may be selected from a wide variety of materials, such as Ti/Pt/Au three-layer alloy, etc., in addition to highly heat-resistant materials.

The thus-fabricated FET has the gate electrode 12 of an about 0.3 µm gate length, and has a high operational speed. A gap between the first doped layer 6 and the gate electrodes 12 is freely adjustable by changing a removal amount of the side surfaces by the plasma etching in the step of FIG. 5.

As described above, according to this embodiment, the FET of the LDD structure having the short-gate length gate electrode can be easily fabricated by the self-alignment process. Since the gap between the low ohmic resistance region and the gate electrode can be freely adjusted by varying the removal amount of the side surfaces, FETs of structures which decrease the source resistances and provides high transfer conductances gm, and FETs of structures which have a little high source resistances but have good voltage-resistant performances can be fabricated.

To be specific, the gap between the ohmic resistant region and the gate electrode can be decreased by decreasing the removal amount of the side surfaces by etching. Such FETs are effectively applicable to devices, such as normal-off FETs, to which lower source resistances are significant. Reversely increasing the removal amount of the side surfaces by etching widens the gap between the ohmic resistant region and the gate electrode, and improved voltage-resistant performance can be obtained. Such FETs are effectively applicable to high-output devices which require high voltage resistances.

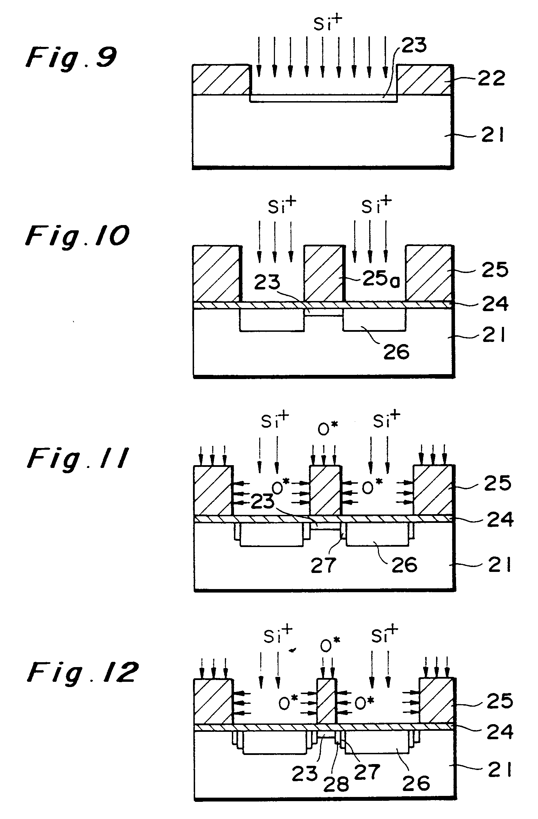

FIGs 9 to 15 are sectional views of the steps of the process for fabricating field-effect transistors according to a second embodiment of this invention. First, a photoresist 22 is spin-applied to a semi-insulating GaAs semiconductor substrate 21. This photoresist 22 is patterned by photolithography for selective removement of the photoresist 22 in a region for an active layer to be formed in. With the patterned photoresist 22 as the masks Si⁺ ions are implanted. This ion implantation forms an active layer 23 on the surface of the semiconductor substrate 21 (FIG. 9).

Subsequently, after the photoresist 22 for the formation of the active layer is removed, a SiN film 24 is formed on the entire surface of the semiconductor substrate 21 by PCVD. This SiN film 24 functions as the surface protection film. Then a photoresist 25 is spin-applied onto the SiN film 24 and patterned by the ordinary photolithography. In this patterning step, parts of the photoresist 25 in a region for a source to be formed in and in a region for a drain to be formed in are removed, while a dummy gate 25a to be a gate electrode is formed. In this embodiment, this dummy gate 25a is formed in a rectangular shape of a 1.5 µm-pattern thickness and a 1.2 µm-pattern width. The first ion implantation is conducted with this photoresist 25 as the mask. In this first ion implantation, a 4x10¹³/cm² concentration of Si⁺ ions are accelerated at a 150 KeV voltage to be additionally implanted into the active layer 23 through the SiN film 24. This first ion implantation forms a first doped layer 26 to be the source and the drain regions (FIG. 10).

Subsequently the first plasma etching of O₂ plasma is conducted to diminish the configuration of the dummy gate 25a. This diminution of the configuration is isotopically conducted by O* radicals with the rectangular shape retained. After the sidewalls of the dummy gate 25a are etched by 0.2 µm, with the diminished dummy gate 25a as the mask, the second ion implantation is conducted. In this ion implantation, a 1x10¹³cm² concentration of Si⁺ ions are accelerated at a 100 KeV to be additionally implanted in the first doped layer 26. This second ion implantation forms a second doped layer 27 which has a smaller thickness and a lower concentration than the first doped layer 26 (FIG. 11).

Subsequently the second plasma etching of O₂ plasma is conducted. The configuration of the once diminished dummy gate 25a is isotopically again diminished by O* radicals. Then after the sidewalls of the dummy gate 25a are etched further by 0.2 µm, with the dummy gate 25a as the mask the third ion implantation is conducted. In this ion implantation, a 5x10¹²/cm² concentration of Si⁺ ions are accelerated at 70 KeV to be additionally implanted in the first and the second doped layers 26, 27. The third ion implantation forms a third doped layer 28 which has a smaller thickness and a lower concentration than the second doped layer (FIG. 12).

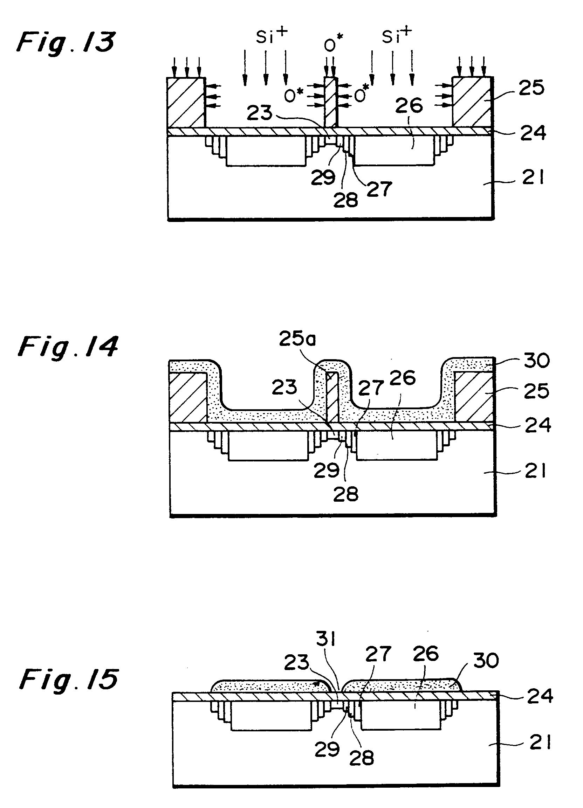

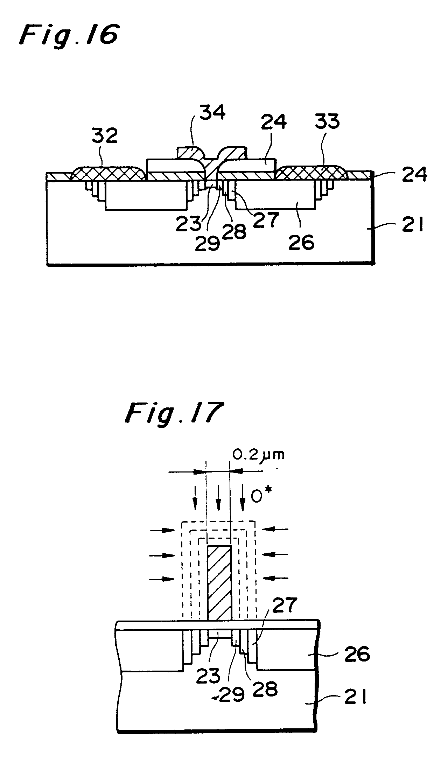

Then the third plasma etching of O₂ plasma is conducted to further diminish the dummy gate 25a. After the sidewalls of the dummy gate 25a are etched by 0.1 µm, with this dummy gate 25a as the mask the fourth ion implantation is conducted. In this ion implantation a 1x10¹²/cm² concentration of Si⁺ ions is accelerated at 50 KeV. This ion implantation forms a fourth doped layer 29 having a smaller thickness and a lower concentration than the third doped layer 28 (FIG. 13). As in FIG. 17, the above-described four-time plasma etching of O₂ plasma gradually isotopically diminish the rectangular configuration of the dummy gate 25a by O* radicals. The dummy gate 25a finally has a 0.2 µm gate length.

Then SiO₂ is deposited on the entire surface of the substrate by CVD using microwave electron cyclotron resonance (ECR) plasma or sputtering to form an insulating film 30 in a 3000 Å-thickness (FIG. 14). Then slight etching using buffered hydrogen fluoride (BHF) follows. The diminished dummy gate 25a is lifted off, and a reverse pattern 31 is formed at the part where the dummy gate 25a has been (FIG. 15). In this state annealing is conducted to activate the dopant ions implanted in the semiconductor substrate 21.

Parts of the SiN film 24 and the insulating film 30, which are in the source region and the drain region are selectively removed by photolithography. A source electrode 32 and a drain electrode 33 are formed in contact with the exposed doped layers 26 - 29. Parts of the SiN film 24 and the insulating film 30 in the reversed pattern 31 are similarly removed, and a gate electrode 34 is formed in Schottky contact with the exposed part of the active layer 23. The end portion of the gate electrode 34 overlaps on the insulating film 30. Thus, a MESFET of FIG. 16 is fabricated. Because the gate electrode 34 is formed after the annealing, the Schottky metal may be selected from a wide variety of materials, such as Ti/Pt/Au three-layer alloy, etc., in addition to highly heat-resistant materials.

In this embodiment, as described above, the respective doped layers 26 - 29 to be the source and the drain regions are formed while the configurations of the dummy gate 25a as the masks for the ion implantations are diminished. Thus, this art is different from the conventional art in which a source and a drain regions are formed as films are formed on the sidewalls of a gate electrode to increase widths of the masks. Accordingly, in this embodiment, it is not necessary to form a small initial dummy gate 25a. The dummy gate 25a is initially formed by the usual optical exposure and is diminished by plasma etching to form the gate electrode 34 of a gate length as short as below 0.5 µm.

Decreases of configurations of the dummy gate 25a can be optional, and regions of the substrate 21 for the ions implantation are defined by intentionally diminishing configurations of the dummy gate 25a as the masks so as to form a source and a drain regions of intended doping profiles. As a result, a source and a drain regions can be formed without too much spacing between the n⁺ heavily doped layer 26 and the active layer 23 from each other, and the gate electrode 34 of a short gate length can be formed with increases of a source resistance suppressed. Because a dopant content of the substrate is lowered toward the active layer 23 below the gate electrode 34, concentration of an electric field at the end portion of the drain region is mitigated, and energy supplied to electrons at the end portion of the drain region is lowered. Accordingly leak currents flowing from the source and the drain regions to below the active layer 23 are suppressed, and the short channel effect is suppressed while a gate electrode of a short gate length can be obtained.

In this embodiment, plasma etching of O₂ plasma is conducted three times, and in each of the plasma etching ion implantation is conducted to form the n⁺layers in four steps. Times of the etching, and those of the ion implantation are not limited to the above times. The times may be varied depending on required characteristics, such as a gate length of a device, a reverse voltage resistance, a transfer conductance gₘ. Such fabrication condition changes still allow the same effect as in this embodiment to be produced.

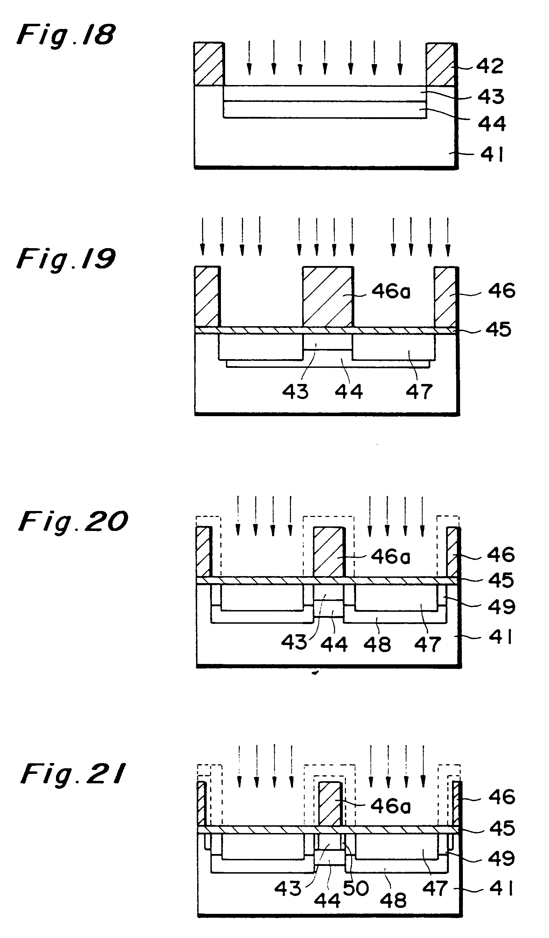

FIGs. 18 to 24 are sectional views of the steps of the process for fabricating field-effect transistors according to a third embodiment of this invention. A photoresist 42 is spin-applied to a semi-insulating GaAs semiconductor substrate 41. This photoresist 42 is patterned by photolithography to selectively remove a part of the photoresist 42 in a region for an active layer to be formed in. With the patterned photoresist 42 as the mask, a 6.0x10¹¹cm² dose of Be⁺ ions is implanted at a 70 KeV acceleration voltage. With the same mask, a 5.0x10¹²/cm² dose of Si⁺ ions is implanted at a 30KeV acceleration voltage. This ion implantation forms on the surface of the semiconductor substrate 41 an active layer 43 to be a channel, and a p-buried layer 44 below the active layer 43 (FIG. 18).

Then, after the photoresist 42 for the formation of the active layer is removed, a 1000 Å-thickness SiN film 45 is formed on the entire surface of the semiconductor substrate 41. This SiN film 45 functions as a surface protective film. A photoresist 46 is spin-applied onto the photoresist film 45. This photoresist 46 is patterned by the usual photolithography. In this patterning, parts of the photoresist 46 in a region for a source region to be formed in and in a region for a drain region to be formed in are removed while a dummy gate 46a for the formation a gate electrode is formed. In this embodiment, this dummy gate 46a is formed in a 1.5 µm-pattern thickness and a 1.2 µm-pattern width rectangular shape. Then, with this photoresist 46 as the mask, ion implantation is conducted. In this ion implantation a 4x10¹³/cm² concentration of Si⁺ ions is accelerated at 120 KeV to be additionally implanted into the active layer 43 and the buried layer 44 through the SiN film 45. This ion implantation forms a first n⁺doped layer 47 which is to be the source region and the drain region (FIG. 19).

Then, plasma etching of O₂ plasma is conducted to diminish the configuration of the dummy gate 46a. The diminution of the configuration is isotopically conducted by O* radicals and retains the rectangular shape. After the sidewalls of the dummy gate 46a are etched, ion implantation is conducted twice with the diminished dummy gate 46a as the mask. Firstly a 6x10¹¹/cm² concentration of Be⁺ ions is accelerated at a 90 KeV voltage to be additionally implanted in the first doped layer 47. Secondly a 6x10¹²/cm² concentration of Si⁺ ions is additionally implanted at a 80 KeV voltage to be implanted in the first doped layer 47. The second ion implantation forms a two-layer doped region constituted by a second p⁺ doped layer 48 and a third n-doped layer 49 is formed around the first doped layer 47. The second doped layer 48 is formed thicker than the first doped layer 47, and the third doped layer 49 is formed thinner in a lower concentration than the first doped layer 47 (FIG. 20).

Then plasma etching of O₂ plasma is again conducted. The reduced configuration of the dummy gate 46a is further isotopically reduced by O* radicals. After the sidewalls of the dummy gate 46a are etched by 0.2 µm, with the dummy gate 46a as the mask the third ion implantation is conducted. In this ion implantation, a 4x10¹²/cm² of Si⁺ ions is accelerated at a 50 KeV voltage to be additionally implanted in the first and the third doped layers 47, 49. This third ion implantation forms a fourth n-doped layer 50 thinner in a lower concentration than the third doped layer 49 (FIG. 21).

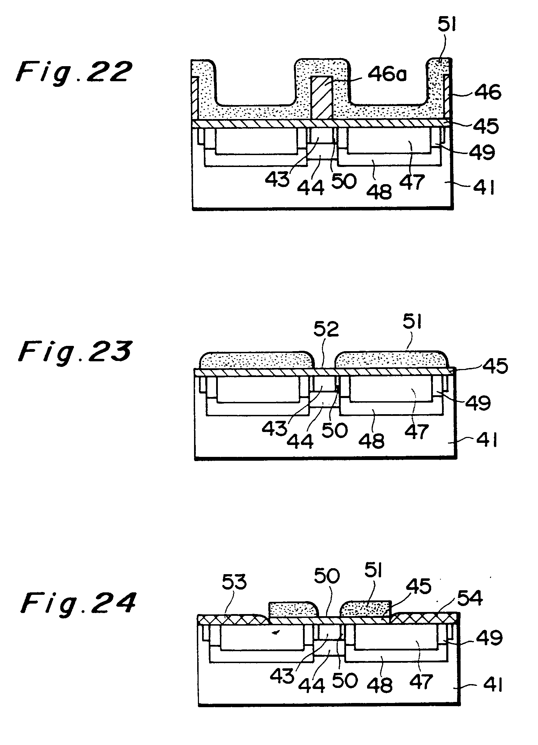

Then SiO₂ is deposited on the entire surface of the substrate by CVD using microwave electron cyclotron resonance (ECR) plasma or sputtering to form an insulating film 51 in a 3000 Å-thickness (FIG. 22). Then slight etching using buffered hydrogen fluoride (BHF) follows. The diminished dummy gate 46a is lifted off, and a reverse pattern 52 is formed at the part where the dummy gate 46a has been (FIG. 23). In this state annealing is conducted to activate the dopant ions implanted in the semiconductor substrate 41.

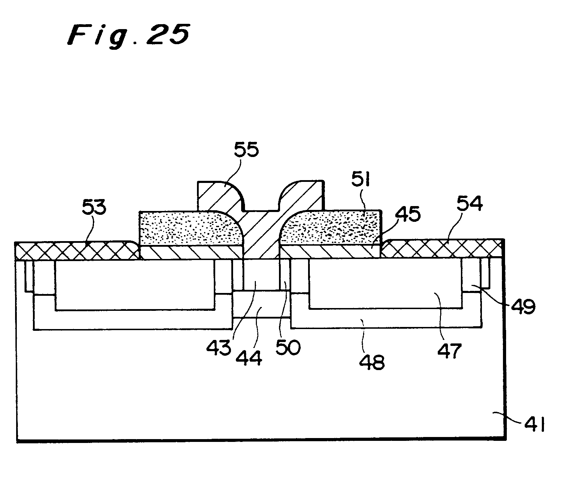

Parts of the SiN film 45 and of the insulating film 51 in the source region and the drain region are selectively removed by photolithography. A source electrode 53 and a drain electrode 54 are formed in contact with the exposed doped layers 47, 49, 50 (FIG. 24). Parts of the SiN film 45 and the insulating film 51 in the reversed pattern 52 are similarly removed, and a gate electrode 55 is formed in Schottky contact with the exposed part of the active layer 43. The end portion of the gate electrode 55 overlaps on the insulating film 51. Thus, a MESFET of FIG. 25 is fabricated. Because the gate electrode 55 is formed after the annealing, the Schottky metal may be selected from a wide variety of materials, such as Ti/Pt/Au three-layer alloy, etc., in addition to highly heat-resistant materials.

In this embodiment, as described above, the third n-doped layer 49 and the second p⁺doped layer 48 are formed on the sidewall of the first n⁺doped layer 47 to be the source and the drain regions on the side of the gate electrode 55. The third doped layer 49 of the same conduction as the first doped layer 47 functions as the channel layer, and a potential barrier is formed in the interface between the second doped layer 48 of the different conduction from the third doped layer 49, and the first doped layer 47. This potential barrier can suppress the generation of leak currents flowing from the first doped layer 47 to below the active layer 43.

Accordingly the short channel effect can be sufficiently suppressed. Even with a gate length less than 0.5 µm, the FET characteristics are not deteriorated, and the resultant device has little deflection in their characteristics. No increases of a gate capacity take place, and good high-frequency characteristics can be obtained. This invention is very effectively applicable to basic devices of below 0.5 µm for digital and analog circuits, and microwave circuits.

The removement of the dummy gate in the etching step of FIG. 21 causes the second doped layer 48 to apart from the gate electrode 55 formed in the following step. As a result, when the dopant diffuses transversely in activating the second doped layer 48, the dopant is prohibited from diffusing down to below the channel layer below the end portion of the gate electrode. Accordingly a concentration of the dopant below the channel layer below the end portion of the gate electrode 55 is never increased, and accordingly a gate capacity is never increased.

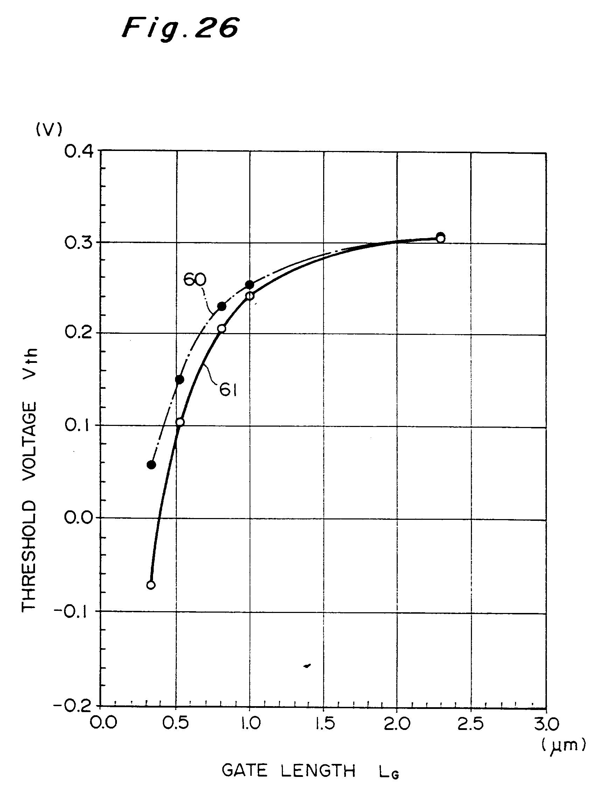

FIG. 26 is a view of relationships between threshold voltages (Vₜₕ) and gate lengths (L_{G}) of the gate electrode 55. The line 60 indicates characteristics of the FET according to this embodiment having the second p⁺doped layer 48 formed inner of the first n⁺doped layer 47. The line 61 indicates characteristics of the conventional FET without the second p⁺doped layer 48, which is formed inner of the first n⁺doped layer 47. As shown in FIG. 26, it is found that the FET according to this embodiment having the second doped layer 48 can suppress shift amounts of a threshold voltage (Vₜₕ) even when a gate length (L_{G}) is decreased.

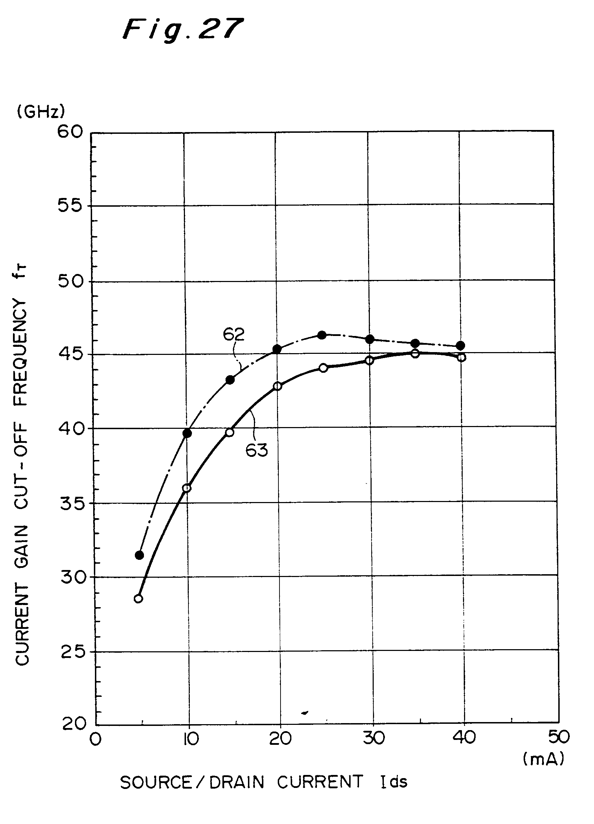

FIG. 27 is a view of relationships between current gain cut-off frequencies (f_{T}) and source-drain currents (I_{ds}). The line 62 indicates characteristics of the FET according to this embodiment having the second p⁺doped layer 48 formed inner of the first n⁺doped layer 47. The line 63 indicates characteristics of the conventional FET without the second p⁺doped layer 48, which is formed inner of the first n⁺doped layer 47. As shown in FIG. 23, it is found that the FET according to this embodiment having the second doped layer 48 have high current gain cut-off frequencies (f_{T}) irrespective of values of source-drain currents (I_{ds}). From this, it is found that even because of transverse diffusion of the dopant of the second doped layer 48, the FET according to this embodiment is free from increases of a gate capacity and can have good high-frequency characteristics.

In addition, the FET according to this embodiment has the characteristic that side gate effect does not easily take place. In the conventional FET having a p-buried layer below an n-channel layer for the suppression of leak currents, when the p-buried layer is heavily doped and fails to meet a complete depletion condition, the FET is susceptible to influences of the ohmic electrodes, etc. of adjacent other FETs through the substrate, and a side gate voltage resistance is adversely lowered. Decreases of a side gate voltage resistance easily cause the side gate effect, and the generation of the side gate effect causes erroneous operations of the circuits. For the prevention of the generation of the side gate effect, means of increasing spaces between devices must be taken. In the FET according to this embodiment, however, as described above, the second doped layer 48 is heavily doped so that the buried layer 44 can maintain a concentration which meets complete depletion conditions. Because the second doped layer 48 is not in contact with the active layer 43, the active layer 43 is free from influences of the ohmic electrodes, etc. of adjacent other FETs through the second doped layer 48. Accordingly in the FET according to this embodiment, decreases of a side gate voltage resistance can be prevented, and the side gate effect does not easily take place.

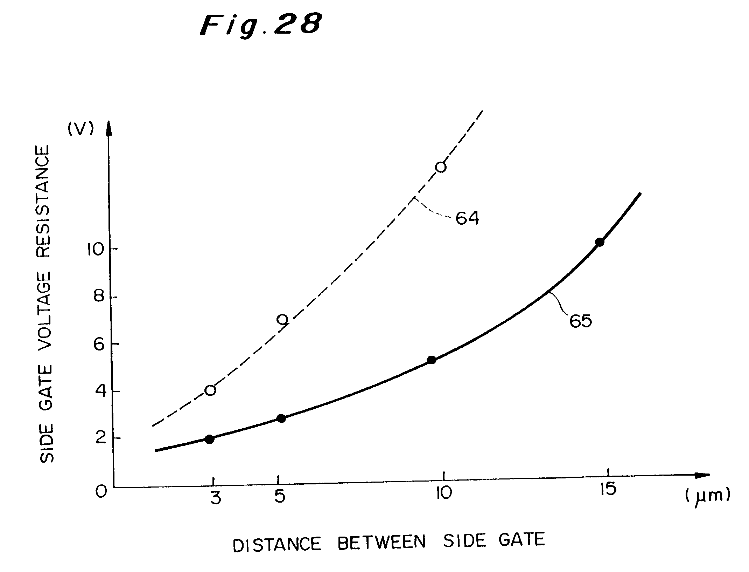

FIG. 28 shows relationships between the conventional FET having a p-buried layer below an n-channel layer and the FET according to this embodiment concerning inter-side gate electrode gaps and side gate voltage resistances. The line 64 indicates those of the FET according to this embodiment. The line 65 indicates those of the conventional FET. It is found from FIG. 28 that the FET according to this embodiment has higher side gate voltage resistances than the conventional FET. The inter-side gate electrode gap means here a distance between the active layer 43 and the ohmic electrode of another adjacent FET.

In the process for fabricating field-effect transistors according to this embodiment, the material of the gate electrode can be optionally selected. The use of Au-based materials makes the resultant FETs applicable to low-noise devices.

In comparison with the conventional fabrication process using T-shaped dummy gates, the process according to this invention is very simple. Accordingly the fabrication process according to this invention is effectively applicable to any field-effect transistor using a semiconductor substrate. In the above-described embodiment, the dummy gates 5a, 25a, 46a are formed of photoresist, but their materials are not necessarily limited to photoresist. Any material which is isotopically reducible in plasma etching and has characteristics for preventing the passing of the implanted ion can be used. The materials of the insulating films 8, 30, 51 on which the reverse patterns 11, 31, 52 are formed are not necessarily limited to SiO₂. Any insulating material whose selective etching ratio with respect to materials of the dummy gates 5a, 25a, 46a is higher can be used. In the above-described embodiments, the material of the semi-insulating semiconductor substrates 1, 21, 41 are GaAs, but they may be InP, InGaAs. The formation of the dummy gates 5a, 25a, 46a, the insulating films 8, 30, 51, and the semiconductor substrates 1, 21 41 still produces the same effects as in the above-described embodiments.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A process for fabricating a field-effect transistor comprising:
a first step of implanting ions in a semiconductor substrate (1; 21; 41) to form an active layer (3; 23; 43);
a second step of forming a dummy gate (5a; 25a; 46a) on the semiconductor substrate (1; 21; 41), and implanting a dopant in the semiconductor substrate (1; 21; 41) with the dummy gate (5a; 25a; 46a) as a mask to form a first doped layer (6; 26; 47);
a third step of reducing a configuration of the dummy gate (5a; 25a; 46a), and implanting a dopant in the semiconductor substrate (1; 21; 41) to form a second doped layer (7; 27; 48, 49);
a fourth step of forming an insulating film (8; 28; 51) using said reduced dummy gate (5a; 25a; 46a); and
a fifth step of removing a part of the insulating film (8; 28; 51) on the first doped layer (6; 26; 47), forming an ohmic electrode (10, 11; 32, 33; 53, 54) in the region with the insulating film (8; 28; 51) removed, lifting off the insulating film using said reduced dummy gate (5; 25a; 46a), and forming a gate electrode (12; 34; 55) in the lifted-off region.

2. A process for fabricating a field-effect transistor according to claim 1,
wherein the second doped layer (7; 27) is of the same conduction as the dopant of the first doped layer (6; 26).

3. A process for fabricating a field-effect transistor according to claim 1 or 2,
wherein in the second step a protective film (4; 24; 45) is formed on the semiconductor substrate (1; 21; 41), and the dummy gate (5a; 25a; 46a) is formed on the protective film (4; 24; 45); and parts of the protective film (4; 24; 45) in a region for the ohmic electrode (10, 11; 32, 33; 53, 54) to be formed in and in a region for the gate electrode (12; 34; 55) to be formed in are removed before the formation of the ohmic and the gate electrodes.

4. A process for fabricating a field-effect transistor according to any one of claims 1 - 3,
wherein in the steps of reducing configurations of the dummy gate (5a; 25a; 46a), configurations of the dummy gate are reduced by partially plasma-etching side surfaces of the dummy gate.

5. A process for fabricating a field-effect transistor according to any of claims 1 - 4,
wherein the third step is repeated required times between the third and the fourth steps.

6. A process for fabricating a field-effect transistor according to claim 5,
wherein a second doped layer (29) formed in a repeated third step is shallower than the first doped layer (28) or preceding one thereof.

7. A process for fabricating a field-effect transistor according to claim 5 or 6,
wherein said second doped layer (29) formed in the repeated third step has a lower concentration than the first doped layer (28) or said preceding second doped layer.

8. A process for fabricating a field-effect transistor according to claim 1,
wherein said second doped layer comprises a lower doped layer (48) formed by implanting a dopant of a different conduction from a dopant of the first doped layer (47), and being deeper than the first doped layer (47), and an upper doped layer (49) formed by implanting a dopant of the same conduction as the dopant of the first doped layer (47) and being shallower than the first doped layer (47).

9. A process for fabricating a field-effect transistor according to claim 8,
wherein a step of reducing a configuration of the dummy gate (46a) is provided between the third and the fourth steps.

10. A process for fabricating a field-effect transistor according to claim 8,
wherein a step of repeating the third step required times is provided between the third and the fourth steps.

11. A field-effect transistor including an active layer (23) for a channel to be formed in, a first doped layer (26) including source and drain regions which are in contact with the active layer (23), and a gate electrode (34) formed on the active layer (23), the field-effect transistor comprising:
a plurality of second doped layers (27, 28, 29) between the active layer (23) and the first doped layer (26).

12. A field-effect transistor according to claim 11,
wherein said second doped layers (27, 28, 29) are shallower in steps toward the active layer (23).

13. A field-effect transistor according to claim 11 or 12,
wherein the second doped layers (27, 28, 29) have dopant concentrations which lower in steps toward the active layer (23).

14. A field-effect transistor comprising an active layer (43) for a channel to be formed in, a first doped layer (47) including a source of a first conduction, and a drain region, an ohmic electrode (53, 54) formed on the first doped layer (47), and a gate electrode (55) formed on the active layer (43), the field-effect transistor comprising:
a second doped layer (48, 49) including, between the active layer (43) and the first doped layer (47), a lower doped layer (48) of a second conduction, and an upper doped layer (49) of a first conduction formed on the lower doped layer (48), a boundary between the lower and the upper doped layers being upper than the first doped layer (47), and a lower end portion of the lower doped layer (48) being lower than the first doped layer (47).

15. A field-effect transistor according to claim 14,
wherein the lower doped layer (48) is spaced from the gate electrode (55) in parallelism with a horizontal surface thereof.
